# EUROPÄISCHE PATENTSCHRIFT

(11) **EP 2 368 152 B1**
(45) Veröffentlichungstag und Bekanntmachung des Hinweises auf die Patenterteilung: **16.08.2017**
(21) Anmeldenummer: 09778702.2
(22) Anmeldetag: 24.09.2009
(51) Int. Cl.: G01Q 40/02, G03F 1/72, G03F 1/74, G03F 1/84, G01Q 30/06, G01Q 80/00, B82Y 35/00

(54) **VERFAHREN ZUM ERMITTELN EINER REPARATURFORM EINES DEFEKTS AN ODER IN DER NÄHE EINER KANTE EINES MUSTERS EINER PHOTOMASKE**
METHOD FOR DETERMINING A REPAIR SHAPE OF A DEFECT ON OR IN THE VICINITY OF AN EDGE OF A FEATURE OF A PHOTOMASK
PROCÉDÉ DESTINÉ À DÉTERMINER UNE FORME DE RÉPARATION D'UN DÉFAUT SUR OU À PROXIMITÉ D'UN BORD D'UN PATRON D'UN PHOTOMASQUE

(30) Priorität: 23.12.2008 DE 102008062928
(43) Veröffentlichungstag der Anmeldung: 28.09.2011
(73) Patentinhaber: Carl Zeiss SMT GmbH, 73447 Oberkochen (DE)
(72) Erfinder: BUDACH, Michael, 63456 Hanau (DE)
(74) Vertreter: Mader, Joachim
(86) Internationale Anmeldenummer: PCT/EP2009/006908
(87) Internationale Veröffentlichungsnummer: WO 2010/072279

(56) Entgegenhaltungen:
- WO-A2-2004/015496
- JP-A- 2003 228 161
- US-A1- 2002 096 635
- US-A1- 2003 104 288
- US-A1- 2007 208 533
- US-A1- 2008 078 229
- US-A1- 2008 131 792
- US-B1- 6 335 129
- US-B1- 6 555 277

## Beschreibung

### 1. Technisches Gebiet

Die vorliegende Erfindung betrifft ein Verfahren zum Ermitteln einer Reparaturform eines Defekts an oder in der Nähe einer Kante eines Substrats einer Photomaske.

### 2. Stand der Technik

Als Folge der stetig steigenden Integrationsdichte in der Halbleiterindustrie müssen Photolithographiemasken immer kleinere Strukturen abbilden. Daher wird die Herstellung von Photomasken immer aufwändiger und damit auch kostspieliger. Die kleiner werdenden Strukturgrößen der Photomasken führen zum Auftreten von neuen, zusätzlichen Fehlern oder Defekten auf den Photomasken. Gleichzeitig führt der wachsende Aufwand bei der Herstellung von Photomasken mit immer kleineren Strukturen und der damit einhergehende Kostendruck dazu, dass Defekte, die bei der Maskenherstellung auftreten, repariert werden müssen, um eine teurere, komplette Neuherstellung einer Photomaske zu vermeiden. Die Anmeldungen DE 103 38 019 A1 und EP 1 587 128 A1 der Anmelderin offenbaren Verfahren zum Reparieren von defekten Oberflächenstrukturen auf Photomasken.

Bevor Defekte auf Photomasken repariert werden können, müssen sie lokalisiert werden. Dies geschieht durch optische Inspektion und durch die Abbildung mit einen Teilchenstrahl (Ionen oder Elektronen) aus einem FIB-Rastermikroskop (Focused Ion Beam) bzw. einen Rasterelektronenmikroskop (SEM, Scanning Electron Microscope). Beim Verwenden eines Elektronenstrahls werden die von den Elektronen von der zu untersuchenden Oberfläche der Photomaske ausgelösten Rückstreu- und Sekundärelektronen verwendet, um ein Bild der Oberfläche der Photomaske zu erzeugen. Beim Einsatz eines fokussierten Ionenstrahls bilden die von den Ionen aus der Substratoberfläche freigesetzten, sekundären Ionen die Zusammensetzung der untersuchten Oberfläche ab (SIMS, Secondary Ion Mass Spectroscopy).

Mit einem Elektronenstrahl funktioniert diese Art der Defektlokalisierung solange das Substrat der zu untersuchenden Oberfläche und der Defekt Materialien aufweisen, die ein signifikant unterschiedliches Emissionsverhalten im Hinblick auf Rückstreu- und/oder Sekundärelektronen aufweisen. Beim Einsatz eines Ionenstrahls muss in ähnlicher Weise die Zusammensetzung der vom Substrat und vom Defekt erzeugten sekundären Ionen unterschiedlich sein, um einen hinreichenden Kontrast zu erhalten.

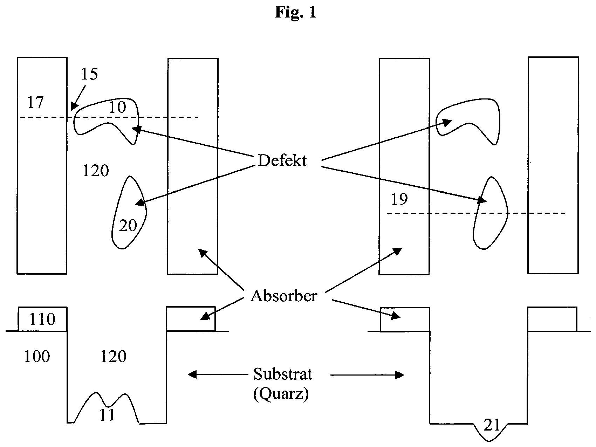

Um immer kleinere Strukturen zu erzeugen, werden Photomasken, die die Phase des Lichts verändern (sogenannte Phase Shift Photomasks) zunehmend wichtiger. Bei diesem Maskentyp wird neben den Strukturen auf der Oberfläche des Substrats auch das Substrat der Photomaske selbst geätzt, das üblicherweise aus Quarz besteht. Beim Abtragen von Substratmaterial der Photomaske kann es jedoch passieren, dass, wie in Fig. 1 dargestellt, Substratmaterial an Stellen verbleibt, an denen es entfernt werden sollte, wodurch sogenannte "Quartz Bumps" entstehen. Oder es tritt der umgekehrte Fall auf, dass an manchen Stellen zuviel Substratmaterial entfernt wird, was zum Entstehen von Löchern oder sogenannten "Quartz Divots" führt (vgl. ebenfalls Fig. 1). Da bei diesen Defekten das Substratmaterial und der Defekt aus demselben Material bestehen, entzieht sich dieser Fehlertyp weitgehend einer präzisen Abbildung mit Hilfe eines Ionen- oder Elektronenstrahls.

Um Photomaskendefekte des beschriebenen Typs zu reparieren, wird der Defekt im Falle eines Quartz Bumps mit einem Teilchenstrahl gegebenenfalls unter Bereitstellen eines Ätzgases bestrahlt, um das überschüssige Substratmaterial zu entfernen. Fehlendes Material wird mit Hilfe eines Teilchenstrahls und unter Verwendung eines geeigneten Depositionsgases an den defekten Stellen deponiert. Damit bei diesen Reparaturprozessen die reparierten Stellen eine im Wesentlichen ebene Oberfläche auf gleichem Niveau wie das den Defekt umgebende Substrat aufweisen, müssen diese Reparaturprozesse entsprechend der Topologie des Defekts gesteuert werden.

Daher ist eine wesentliche Voraussetzung für die Reparatur dieser Defekte die Kenntnis der dreidimensionalen Kontur des Defekts. Wie oben beschrieben, kann die Topologie der Defekte mittels eines Rasterelektronenmikroskops (SEM) oder eines FIB-Rastermikroskops nicht hinreichend genau bestimmt werden.

Zur Vermessung der Kontur des Defekts bietet sich ein Kraftmikroskop (AFM, Atomic Force Microscope) an. Der Einsatz eines AFM in diesem Zusammenhang ist beispielsweise in dem Artikel "Advancements in Focused Ion Beam Repair of Alternating Photo Masks" von Joshua Lessing, Tod Robinson, Troy Morrison and Theresa Holtermann, erschienen in den Proceedings of SPIE, Vol. 5256, 23rd Annual BACUS Symposium on Photomask Technology, edited by Kurt R. Kimmel, Wolfgang Staud, Seiten 1208 - 1221, beschrieben. Ferner offenbart die US-Anmeldung US 2004/0121069 A1 das Verwenden eines AFMs (Kraftmikroskops) zum Bestimmen der Konturen der oben beschriebenen Photomaskendefekte.

Der Einsatz eines abtastenden oder rasternden AFMs funktioniert gut bei isolierten Defekten, wie in Fig. 1 dargestellt. Der Einsatz eines AFMs führt jedoch zu Problemen, wenn die abzubildende Oberflächenstruktur ein bestimmtes Aspektverhältnis, d.h. des Verhältnisses aus der Tiefe bzw. Höhe einer Struktur zu ihrer kleinsten lateralen Ausdehnung überschreitet. Dies tritt insbesondere an oder in der Näher einer Kante einer Oberflächenstruktur des Substrats der Photomaske auf. AFMs haben in diesem Fall die prinzipielle Eigenschaft, die Konturen der beschriebenen Defekte nicht getreu wiederzugeben, da der Durchmesser der abtastenden Spitze dieser Geräte nicht wesentlich kleiner ist als die abzubildenden Strukturen. Dieses prinzipielle messtechnische Problem lässt sich auch durch mathematische Operationen, die in dem Artikel *"*Algorithms for Scanned Probe Microscope Image Simulation, and Tip Estimation" von J.S. Vullarrubia, erschienen in J. Res. Natl. Inst. Stand. Technol. 102, 425 (1997) beschrieben werden, nicht vollständig beseitigen.

Der vorliegenden Erfindung liegt daher das Problem zu Grunde, ein Verfahren zum Ermitteln einer Reparaturform eines Photomaskendefekts anzugeben, das die oben genannten Nachteile beim Ermitteln der Grenze eines Defekts entlang einer Kante des Substrats der Photomaske zumindest zum Teil vermeidet.

Die JP 2003 2 281 161 A offenbart ein Verfahren zum Reparieren von Defekten auf einer Photomaske. Die Ionenstrahldosisverteilung, die für die Reparatur des Defekts notwendig ist, wird durch Kombinieren der dreidimensionalen Messung des Defekts durch ein Kraftmiskroskop (AFM) und die Simulation des Höhenprofils bestimmt. Der Ionenstrahl wird selektiv gescannt während Hilfsgas durch eine Gaskanone zur Korrektur des dunklen Defekts geliefert wird und während ein gasförmiges Rohmaterial für einen Abschirmungsfilm zur Korrektur des beleuchteten Defekts in Übereinstimmung mit der berechneten Dosisverteilung geliefert wird. Dadurch wird der Defekt einer Defektreparatur mit großer Genauigkeit und hoher Qualität unterworfen.

Die US 2008 / 0 131 792 A1 beschreibt eine Mikrobearbeitungsvorrichtung, die mit einem AFM ausgerüstet ist, das eine Mehrzahl von unabhängig von einander ansteuerbaren Messspitzen aufweist. Die Mikrobearbeitungsvorrichtung verwendet einen Elektronenstrahl oder einen Helium-Ionen-Strahl, der durch eine Gasfeldionenquelle erzeugt wird, ein isolierendes Muster, das den Defekt umfasst, wird durch eine leitfähige Messspitze geerdet, die in Kontakt mit dem Muster gebracht wird. Der opake Defekt wird korrigiert wobei das Aufladen durch einen Elektronenstrahl oder einen Helium-Ionen-Strahl verhindert wird. Im dem Falle in dem ein isolierendes Musters in einem Beobachtungsbereich vorhanden ist und der Aufladungseffekt selbst dann auftritt, wenn das isolierende Muster geerdet ist, wird das entsprechende isolierende Material durch die Mehrzahl der leitfähigen Messspitzen geerdet ist, um dadurch den Aufladungseffekt zu unterdrücken.

Die US 2002 / 0 096 635 A1 beschreibt ein Verfahren, bei dem in einem ersten Schritt ein Bereich einer Photomaske, der einen Defekt und ein Pattern-Element enthält, mit einem AFM observiert. Aus der Observation werden die Position und die Form des Defekts bestimmt. Das extrahierte Pattern wird dann in ein Shape-Format für eine Ionen-strahl-Defektreparaturvorrichtung umgewandelt und gespeichert. Das extrahierte / konvertierte Positionsausrichtungs-Pattern wird mit einen Pattern kombiniert, das einem Sekundärelektronen- oder einem Sekundärionen-Bild entspricht. Die Reparatur wird dann nach Abgleichen des konvertierten Positionsausrichtungs-Patterns mit dem Pattern des Sekundärelektronen-Bildes ausgeführt.

Die US 2003 / 0 104 288 A1 beschreibt das Erzeugen eines Referenzbildes eines Teils einer Photomaske, um einem Photomasken-Inspektions- und Analyse-System zu ermöglichen, das anders kein Referenzbild von einer Referenz-Die oder von digitalisierten Design-Daten erzeugen kann, eine Maskenanalyse unter Verwendung des Referenzbildes durchzuführen. Das Referenzbild wird durch Identifizieren eines Defekts oder einer Verunreinigung der Maske in dem Gegenstandsbild und durch Modifizieren des Gegenstandsbildes zum Entfernen des Defekts oder der Verunreinigung von der Maske zum Erzeugen des Referenzbildes durchgeführt.

Die WO 2004 / 015 496 A2 beschreibt ein Verfahren das topographische Daten eines Rastersondenmikroskops oder eines ähnlichen Geräts als Ersatz für eine Endpunktdetektion nutzt, um eine präzise Reparatur der Defekte phasenschiebender Photomasken unter Verwendung eines System, das einen geladenen Teilchenstrahl verwendet, zu ermöglichen. Die topographischen Daten einer Defektfläche werden verwendet, um eine semitransparente topographische Karte zu erzeugen, die einem Bild überlagert wird, das von geladenen Teilchenstrahlsystem aufgenommen wurde. Die Dichte der topographischen Bilder und die Ausrichtung der beiden Bilder können von einem Anlagenbediener eingestellt werden, um den Strahl präzise zu positionieren.

### 3. Zusammenfassung der Erfindung

Gemäß einem Ausführungsbeispiel der vorliegenden Erfindung wird dieses Problem durch ein Verfahren nach Anspruch 1 gelöst. In einer Ausführungsform umfasst das Verfahren zum Ermitteln einer Reparaturform eines Defekts an oder in der Nähe einer Kante eines Substrats einer Photomaske das Scannen des Defekts mit einem Rastersondenmikroskop zum Bestimmen einer dreidimensionalen Kontur des Defekts, das Scannen des Defekts mit einen Rasterteilchenmikroskop zum Bestimmen eines Verlaufs der zumindest einen Kante des Substrats und das Ermitteln der Reparaturform des Defekts aus einer Kombination der dreidimensionalen Kontur und dem Verlauf der zumindest einen Kante.

Dabei bezieht sich der Ausdruck "in der Nähe einer Kante" auf den Durchmesser der Spitze eines AFMs in Bezug auf die Höhe der Kante. Ein Defekt eines Substrats oder einer Struktur einer Photomaske liegt nicht in der Nähe einer Kante des Substrats oder der Struktur, wenn die dreidimensionale Kontur des Defekts mit Hilfe eines AFMs bestimmt werden kann, ohne dass die oben beschriebenen Messprobleme auftreten.

Mit dem Rastersondenmikroskop wird ein erster Scan des zu reparierenden Bereichs und mit dem Rasterteilchenmikroskop wird ein zweiter Scan des zu reparierenden Bereichs durchgeführt. Aus dem ersten und dem zweiten Scan wird dann die Reparaturform ermittelt, wobei die Reparaturform noch entlang der Kante reduziert werden kann, so dass die endgültig der Reparatur zu Grunde gelegte Reparaturform einen geringfügigen Abstand von der Kante aufweisen kann.

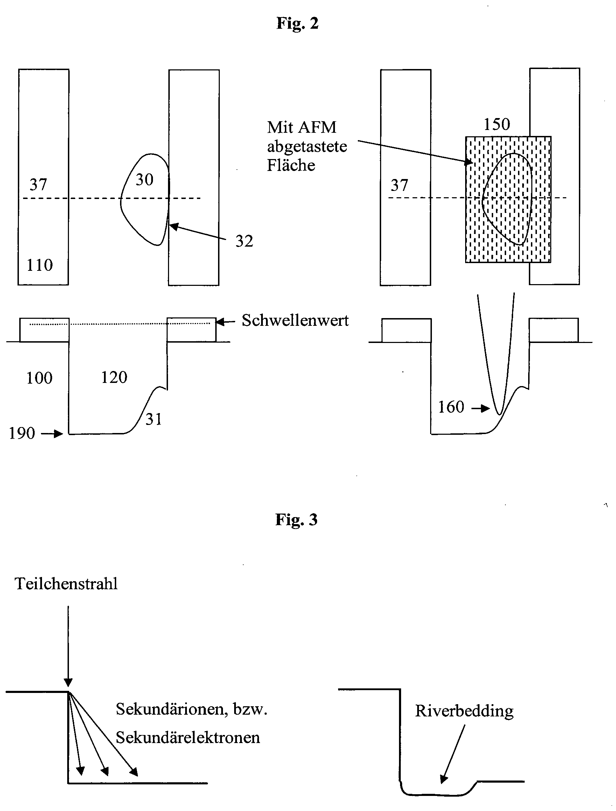

Durch das Ermitteln der Ausdehnung eines Defekts entlang einer Kante der Photomaske anhand der Daten eines Rasterteilchenmikroskop-Scans werden die Messprobleme, die AFMs in diesem Bereich aufweisen, umgangen. Damit kann der Grenzbereich zwischen dem Defekt und einer Kante des Substrats der Photomaske mit größerer Genauigkeit als im Stand der Technik erfasst werden. Dies ist von besonderem Vorteil, da bei der Reparatur des Defekts der Teilchenstrahl des Rasterteilchenmikroskops an den Kanten eine erhöhte Sekundärelektronenemission oder Sekundärionenemission hervorruft, was beispielsweise zu sogenanntem "Riverbedding" führen kann (siehe Fig. 3). Das erfindungsgemäße Verfahren verursacht keinen zusätzlichen apparativen Aufwand, da eine Teilchenstrahlapparatur zur Lokalisierung und zur Reparatur des Defekts ohnehin benötigt wird.

In einer besonders bevorzugten Ausführungsform umfasst die Kombination der dreidimensionalen Kontur mit dem Verlauf der zumindest einen Kante das Bilden einer Schnittmenge aus der dreidimensionalen Kontur und dem Verlauf der Kante.

In einer bevorzugten Ausführungsform umfasst das Rastersondenmikroskop ein Kraftmikroskop und das Rasterteilchenmikroskop ein Rasterelektronenmikroskop.

In einer weiteren bevorzugten Ausführungsform wird der Verlauf der Kante aus Topologiekontrastdaten und/oder Materialkontrastdaten des Rasterteilchenmikroskop-Scans bestimmt.

In einer besonders bevorzugten Ausführungsform wird die Schnittmenge durch den Schritt des Ausrichtens des Rastersondenmikroskop-Scans an dem aus dem Rasterteilchen-Mikroskop bestimmten Verlauf der Kante und den Schritt des Schneidens der Daten des Rastersondenmikroskop-Scans an dieser Kante bestimmt.

In einer bevorzugten Ausführungsform umfasst die Reparaturform Koordinaten des Defekts in einer Ebene seiner maximalen Ausdehnung senkrecht zu der Teilchenstrahlrichtung und eine Teilchenstrahldosis zum Reparieren des Defekts.

In einer besonders bevorzugten Ausführungsform ist die Reparaturform in eine Anzahl von diskreten Punkten eingeteilt und jeder Punkt umfasst eine Teilchenstrahldosis, die aus den Daten des Rastersondenmikroskop-Scans ermittelt wird.

In einer weiteren bevorzugten Ausführungsform wird die Teilchenstrahldosis der einzelnen Punkte der Reparaturform aus einer Interpolation mehrerer Punkte des Rastersondenmikroskop-Scans ermittelt.

In einer bevorzugten Ausführungsform hält die Reparaturform des Defekts entlang zumindest einer Kante der Photomaske zumindest einen Mindestabstand ein. Damit soll sichergestellt werden, dass keine stark fehlerbehaftete Teilchenstrahldosis für die Reparatur der Photomaske verwendet wird. Zudem verhindert ein definierter Abstand zu einer Kante erhöhte Sekundärelektronenemission bei der Reparatur dieses Bereichs des Defekts und die damit in Zusammenhang stehenden Probleme (vgl. Fig. 3).

In einer weiteren bevorzugten Ausführungsform ragt die Reparaturform des Defekts entlang zumindest einer Kante der Photomaske zumindest einen Mindestbereich in diese hinein. Durch dieses Vorgehen beim Reparieren der Photomaske soll gewährleistet werden, dass keine Reste des Defekts entlang einer Kante verbleiben.

In einem Ausführungsbeispiel wird eine Reparaturform nach einer der oben genannten Ausführungsformen zum Reparieren einer Photomaske verwendet.

In einem Ausführungsbeispiel umfasst eine Vorrichtung zum Ermitteln einer Reparaturform eines Defekts an oder in der Nähe einer Kante eines Substrats einer Photomaske, zumindest ein Rastersondenmikroskop zum Scannen des Defekts und zum Übertragen der gescannten Daten, zumindest ein Rasterteilchenmikroskop zum Scannen des Defekts und Übertragen der gescannten Daten, und zumindest eine Datenverarbeitungseinheit, die aus den Daten des Rastersondenmikroskop-Scans eine dreidimensionale Kontur des Defekts bestimmt, aus den Daten des Rasterteilchenmikroskop-Scans einen Verlauf zumindest einer Kante des Substrats bestimmt und die Reparaturform des Defekts aus einer Kombination der dreidimensionalen Kontur und dem Verlauf der zumindest einen Kante ermittelt.

Weitere Ausführungsformen des erfindungsgemäßen Verfahrens und der erfindungsgemäßen Vorrichtung sind in weiteren abhängigen Patentansprüchen definiert.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung von Photomaskendefekten in Aufsicht (obere Teilbilder) und Schnittbilder an den Stellen der gestrichelten Linien (untere Teilbilder) zeigt, die isoliert von einer Kante der Photomaske lokalisiert sind;
- Fig. 2: im oberen linken Teilbild eine schematische Darstellung eines Photomaskendefekts in Aufsicht zeigt, der sich entlang einer Kante der Photomaske erstreckt, sowie die von einem AFM abgetastete Fläche angibt (oberes rechtes Teilbild) und die unteren Teilbilder jeweils Schnittbilder an den durch die gestrichelten Linien gekennzeichneten Stellen darstellen;
- Fig. 3: eine schematische Darstellung des durch Sekundärelektron- bzw. Sekundärionenemission an einer Kante der Photomaske verursachten Riverbeddings zeigt;
- Fig. 4: eine schematische Darstellung der dreidimensionalen Kontur des Defekts in der Ebene der größten Ausdehnung senkrecht zu der Teilchenstrahlrichtung zeigt, wie sie aus den Daten des AFM-Scans ermittelt wurde (oberes Teilbild), und das untere Teilbild ein Schnittbild darstellt;
- Fig. 5: wiederholt die Fig. 2 mit dem Unterschied, dass nun die mit einem SEM gescannte Fläche über dem Defekt dargestellt ist;
- Fig. 6: eine schematische Darstellung des Verlaufs der Kante wiedergibt, der aus den Daten des SEM-Scans über die abgetastete Fläche ermittelt wurde (oberes Teilbild) und ein Schnittbild des Verlaufs der Kante (unteres Teilbild) zeigt;
- Fig. 7: eine schematische Darstellung der Grundfläche der Reparaturform des Defekts in der Ebene der größten Ausdehnung senkrecht zu der Elektronenstrahlrichtung, ermittelt aus der dreidimensionalen Kontur und dem Verlauf der Kante, zeigt;
- Fig. 8: die Fig. 2 mit einem anderen Defekt, einer abgewinkelten Kantenstruktur und einer anderen von dem AFM und dem SEM gescannten Fläche darstellt;
- Fig. 9: eine schematische Darstellung der dreidimensionalen Kontur des Defekts in der Ebene der größten Ausdehnung senkrecht zu der Elektronenstrahlrichtung (linkes oberes Teilbild) und eine schematische Darstellung des Verlaufs der Kante (oberes rechtes Teilbild) zeigt, sowie Schnittbilder an den bezeichneten Stellen darstellt (untere Teilbilder);
- Fig. 10: eine schematische Darstellung der Grundfläche der Reparaturform des Defekts in der Ebene der größten Ausdehnung senkrecht zu der Teilchenstrahlrichtung, wie sie aus der dreidimensionalen Kontur und der Schnittmenge der dreidimensionalen Struktur mit dem Verlauf der Kante ermittelt wurde, zeigt.

### 5. Detaillierte Beschreibung bevorzugter Ausführungsbeispiele

Im Folgenden werden bevorzugte Ausführungsformen des erfindungsgemäßen Verfahrens und der erfindungsgemäßen Vorrichtung genauer erläutert.

Die Fig. 1 zeigt schematisch einen Ausschnitt aus einer die Phase des Lichts formenden Photomaske. Dabei geben die beiden oberen Teilbilder eine Aufsicht wieder und die beiden unteren Teilbilder stellen Schnitte senkrecht zu den gestrichelten Linien 17, 19 der oberen Teilbilder dar. Das Substrat 100 der Photomaske besteht in diesem Ausführungsbeispiel aus Quarz. Das im Folgenden detailliert beschriebene Verfahren kann jedoch auf alle Substratmaterialien angewendet werden, die für die zu verwendende Wellenlänge der optischen Strahlung günstige Eigenschaften aufweisen. Zum Verändern der Phase der Belichtungsstrahlung weist das Substrat 100 zwischen zwei absorbierenden Strukturen 110 eine Vertiefung 120 in dem Quarzsubstrat 100 auf, deren Tiefe mit der Wellenlänge der Belichtungstrahlung korreliert. Die Licht absorbierenden Strukturen 110 bestehen in dem Ausführungsbeispiel der Fig. 1 ebenso wie in den nachfolgenden Figuren aus Chrom. Andere Absorbermaterialien wie beispielsweise Aluminium können ebenfalls verwendet werden. Außerdem ist die Erfindung auch bei reinen die Phase formenden Masken einsetzbar, bei denen die Struktur nur aus Höhenprofilen besteht und dementsprechend keine Absorbermaterialien vorhanden sind.

Der vertiefte Bereich 120 des Substrats 100 der Photomaske weist in der Fig. 1 zwei Fehler oder Defekte 10, 20 auf. Wie aus dem unteren linken Teilbild zu entnehmen ist, stellt der Defekt 10 einen sogenannten "Quartz Bump" dar, d.h. einen Bereich indem nicht genügend Substratmaterial 100 abgetragen wurde. Das untere linke Teilbild gibt einen Schnitt 11 durch den Defekt 10 an der Position der gestrichelten Linie 17 an. Ein AFM kann die dreidimensionale Kontur des Defekts 10 bis auf den Bereich an der Kante 15 des Substrats 100 gut abtasten.

In dem Bereich des Defekts 20 war der Abtrag des Substratmaterials 100 größer als beabsichtigt, was zu der Ausbildung einer zusätzlichen Vertiefung oder eines "Quartz Divot" in dem abgesenkten Substratbereich 120 geführt hat. Das untere rechte Teilbild präsentiert einen Schnitt 21 durch den Defekt 20 an der durch die gestrichelte Linie 19 des oberen rechten Teilbilds angegebenen Position. Da der Defekt 20 an allen Stellen einem Scan eines AFMs zugänglich ist, lässt sich seine dreidimensionale Kontur mit diesem Gerät mit einer für die Reparatur des Defekts 20 hinreichenden Genauigkeit erfassen.

Die Fig. 2 stellt, wie die Fig. 1, einen Ausschnitt aus einer die Phase der optischen Strahlung formenden Photomaske dar. Wie das linke obere Teilbild zeigt, erstreckt sich in diesem Beispiel der Defekt 30 in der Vertiefung 120 des Substrats 100 entlang einer Kante 32. Das linke untere Teilbild präsentiert einen Schnitt 31 durch den Defekt 30 an der mit der gestichelten Linie 37 gekennzeichneten Position. In dem rechten oberen Teilbild ist die Fläche 150 eingezeichnet, die ein AFM abtastet, um eine dreidimensionale Kontur des Defekts 30 zu bestimmen. Die Spitze des AFMs bewegt sich bei dem Messvorgang entlang der strichlierten Linien der Fläche 150. Die Höhe der Oberfläche des Absorbers 110 wird, wie im linken unteren Teilbild dargestellt, mittels eines Schwellenwerts diskriminiert.

Bei dem Defekt 30 treten beim Bestimmen seiner dreidimensionalen Kontur entlang der Kante 32 mit einem AFM die bereits erwähnten prinzipiellen Messprobleme auf. In dem rechten unteren Teilbild ist schematisch die Spitze 160 des AFMs dargestellt. Der Durchmesser der Messspitze ist nicht wesentlich kleiner als die Abmessungen der abzubildenden Strukturen. Zudem vergrößert sich der Durchmesser entlang der Längsachse der Messspitze. Damit kann ein AFM prinzipbedingt nur Strukturen wirklichkeitsnah abbilden oder wiedergeben, die ein bestimmtes Aspektverhältnis (Verhältnis aus der Tiefe bzw. Höhe einer Struktur zu ihrer kleinsten lateralen Ausdehnung) nicht überschreiten. In einem Bereich entlang der Kante 32 wird dieses Aspektverhältnis überschritten und das AFM kann in diesen Bereich die dreidimensionale Kontur des Defekts 30 nicht wirklichkeitsnah reproduzieren. Wie bereits oben erwähnt, lässt sich diese Situation durch mathematische Optimierungsmethoden verbessern; die prinzipbedingten Messprobleme können damit jedoch nicht beseitigt werden.

Eine genaue Bestimmung des Verlaufs des Defekts 30 entlang der Kante 32 der Vertiefung 120 des Substrats 100 ist allerdings für seine Reparatur von entscheidender Bedeutung. Wie in der Fig. 3 schematisch dargestellt ist, erzeugt der zur Reparatur eines Defekts verwendete Teilchenstrahl im Bereich einer Kante eine erhöhte Emissionsrate von Sekundärelektronen bzw. Sekundärionen, die in dem vertieften Bereich 120 des Substrats 100 zu Schäden in dem von den Sekundärelektronen bzw. -ionen bestrahlten Gebiet unter anderen zu sogenanntem "Riverbedding" führen kann. Für eine nebenwirkungsarme Reparatur des Defekts 30 ist deshalb die Kenntnis des genauen Verlaufs des Defekts 30 entlang der Kante 32 und insbesondere der Verlauf der Kante selber sehr wichtig. Denn - wie oben erläutert - löst die Kante das sogenannte "Riverbedding" aus.

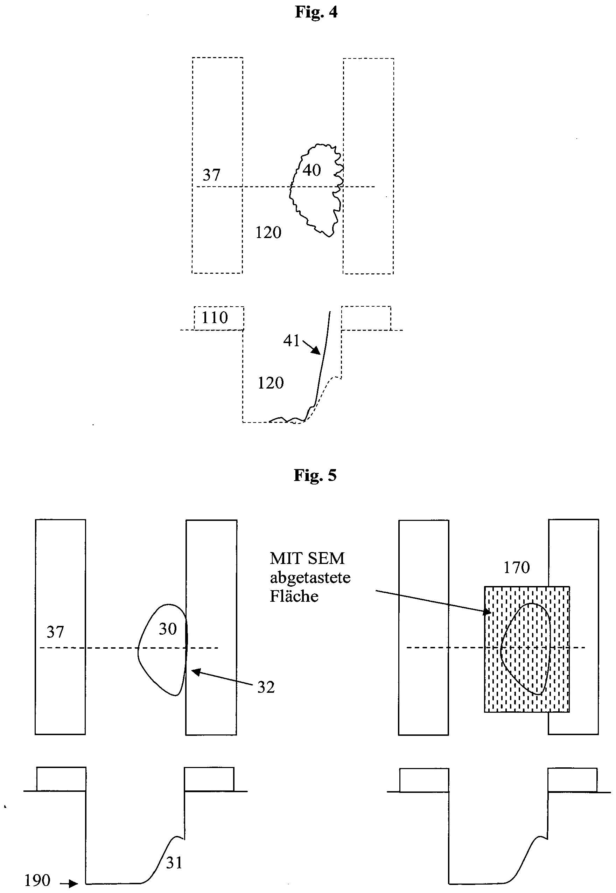

Die Figur 4 präsentiert schematisch die aus dem AFM-Scan bestimmte dreidimensionale Kontur 40 des Defekts 3, dabei zeigt das obere Teilbild eine Aufsicht auf die dreidimensionale Kontur 40 und das untere Teilbild gibt einen Schnitt 41 durch die Kontur 40 entlang der Linie 37 wieder. Zur Verdeutlichung der Lage des Defekts 30 sind in der Fig. 4 zusätzlich gestrichelt die benachbarten Absorberstrukturen 110 sowie die Vertiefung 120 des Substrats 100 eingezeichnet.

Aus einem Vergleich der Figuren 2 und 4 wird ersichtlich, dass die dreidimensionale Kontur 40 die maximale Ausdehnung des Defekts 30 in der Ebene 190 des Bodens der Vertiefung 120 des Substrats 100, d.h. seine Grundfläche gut reproduziert. Desgleichen bildet die dreidimensionale Kontur 40 die Höhe des Defekts 30 in einem gewissen Mindestabstand von der Kante 37 wirklichkeitsnah ab. Andererseits bildet die dreidimensionale Kontur 40 entlang der Kante 32 die Oberfläche des Defekts 30 nicht gut ab. Zum einen variieren die Koordinaten der Grundfläche entlang der Kante 32 (oberes Teilbild) ziemlich stark und zum anderen korreliert die Höhe der Kontur 40 nicht gut mit der Höhe des Defekts 30 in diesem Bereich, wie der Schnitt 41 and der Position 37 schematisch zeigt (unteres Teilbild).

Die Fig. 5 reproduziert nochmals die Fig. 2 mit dem Unterschied, dass in Fig. 5 die Fläche 170, die in der Größe der Fläche 150 der Fig. 2 entspricht, statt mit einem AFM nun mit einem SEM (Rasterelektronenmikroskop) gescannt wird. Der Defekt 30 lässt sich anhand des SEM-Scans kaum erkennen, da er, wie bereits oben erwähnt keinen Materialkontrast liefert. Der Defekt 30 ergibt zudem nur einen schwachen Topologiekontrast, da er in der Regel keine scharfen Begrenzungen aufweist.

Dagegen zeichnet sich die Kante 32 in dem SEM-Scan deutlich ab, zumal sie in dem Beispiel der Fig. 5 die Grenze zweier verschiedener Materialien bildet: des Chromabsorbers 110 und des Quarzsubstrats 100. Damit zeichnet sich die Kante 32 in dem SEM-Scan zum einen durch einen starken Materialkontrast ab. Die Kante 32 stellt zusätzlich eine scharf begrenzte Stufe dar, die ein Topologiekontrastsignal liefert. Damit kann aus dem SEM-Scan die Kante 32 zuverlässig bestimmt werden.

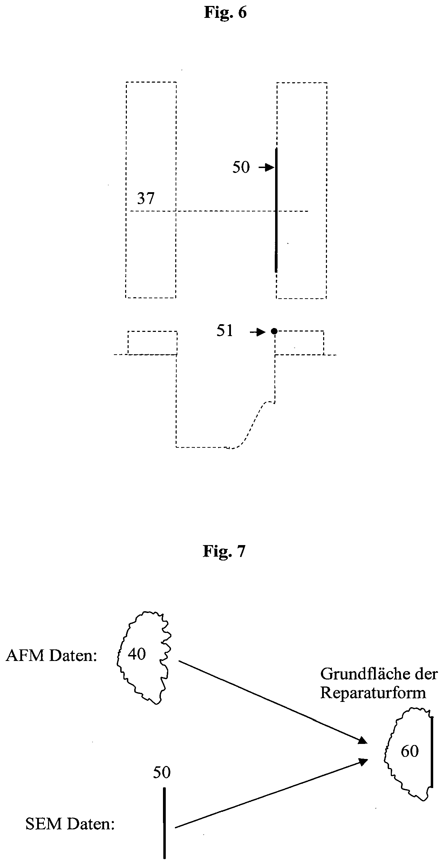

Die Fig. 6 stellt schematisch als Ergebnis den aus dem SEM-Scan bestimmten Verlauf 50 der Kante 32 dar (oberes Teilbild) und einen Schnitt 51 entlang der gestrichelten Linie 37 (unteres Teilbild). Zur Veranschaulichung des Verlaufs 50 der Kante 32 sind in der Fig. 6 zusätzlich gestrichelt die benachbarten Absorberstrukturen 110 sowie die Vertiefung 120 des Substrats 100 eingezeichnet.

In dem Beispiel der Fig. 5 weist der SEM-Scan, der zum Bestimmen des Verlaufs 50 der Kante 32 verwendet wird, sowohl Materialkontrast- als auch Topologiekontrastanteile auf. Dies ist für das Ausführen des erfindungsgemäßen Verfahrens nicht notwendig. Der Verlauf der Kante 32 kann allein aus Topologiekontrastdaten eines SEM-Scans bestimmt werden kann. Dies bedeutet die Absorberstruktur aus Chrom 110 muss entlang der Kante 32 der Vertiefung 120 des Quarzsubstrats 100 nicht vorhanden sein. Umgekehrt kann der Verlauf 50 der Kante 32 allein aus Materialkontrastdaten eines SEM-Scans bestimmt werden.

Die Fig. 7 veranschaulicht schematisch wie aus der dreidimensionalen Kontur 40 und aus dem Verlauf 50 der Kante 32 der Vertiefung 120 des Substrats 100 die Reparaturform 60 des Defekts 30 ermittelt wird. Für diesen Zweck wird - falls erforderlich - der Maßstab der dreidimensionalen Kontur 40 an den Maßstab des Abbilds 50 der Kante 32 angepasst. Sodann wird die Kontur 40 an dem Verlauf 50 der Kante 32 ausgerichtet. Im nächsten Schritt wird die Kontur 40 an dem Verlauf 50 der Kante 32 geschnitten. Der Verlauf 50 der Kante 32 bildet die Begrenzung der Reparaturform 60 entlang der Kante 32 der Vertiefung 120 des Substrats 100. Die Koordinaten der Begrenzung der Reparaturform 60 in der Ebene 190 (Grundfläche der Reparaturform 60) entlang der Kante 32 haben somit ihren Ursprung in dem SEM-Scan. Die zu diesen Koordinaten gehörenden Höhendaten werden aus der dreidimensionalen Kontur 40 des AFM-Scans ermittelt. Die übrigen Daten der Reparaturform 60 werden ebenfalls aus der dreidimensionalen Kontur 40 bestimmt.

In dem anhand der Figuren 2 - 7 erläuterten Beispiel weist die Reparaturform 60 diskrete Punkte in der Ebene 190 des Bodens der Vertiefung 120 des Substrats 100 auf (Grundfläche der Reparaturform 60). Jedem einzelnen dieser Punkte ist eine Teilchenstrahldosis zugeordnet, die zum Beseitigen des Defekts 30 an der jeweiligen Stelle notwendig ist. Dabei wird die Teilchenstrahldosis aus der Höhe der dreidimensionalen Kontur 40 an diesem Punkt bestimmt. Ist die Schrittweite des AFM- und des SEM-Scans gleich groß und können diese perfekt zueinander ausgerichtet werden, so ist die Teilchenstrahldosis der Reparaturform 60 proportional zu der Höhe der dreidimensionalen Kontur 40 des AFM-Scans an den einzelnen Rasterpunkten. Stimmt der Abgleich der beiden Scans nicht perfekt überein oder sind die Schrittweiten der beiden Scans nicht gleich groß und ist insbesondere die Auflösung des AFM-Scans unterschiedlich zu der des SEM-Scans, dann bilden die Rasterpunkte des SEM-Scans die Koordinaten der Grundfläche der Reparaturform 60. Die Bestimmung der Teilchenstrahldosis der einzelnen Punkte der Reparaturform 60 erfolgt durch Interpolation über die Höhenwerte mehrerer Punkte der dreidimensionalen Kontur 40.

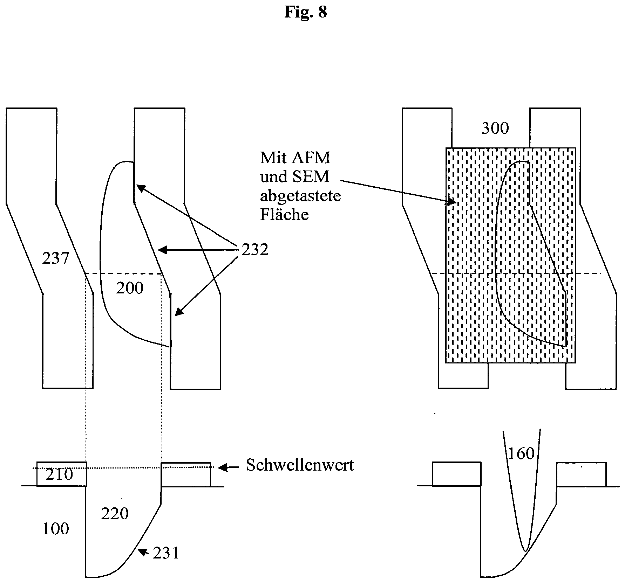

Die nachfolgenden Figuren 8 bis 10 veranschaulichen ein zweites Ausführungsbeispiel des erfindungsgemäßen Verfahrens. Die Fig. 8 stellt, analog zu Fig. 2 einen Ausschnitt aus einer die Phase der optischen Strahlung formenden Photomaske dar. Wie das linke obere Teilbild zeigt, erstreckt sich in diesem Beispiel der Defekt 200 in der Vertiefung 220 des Substrats 100 entlang der abgewinkelten Kante 232. Beidseits der Vertiefung weisen die abgewinkelten Kanten eine Absorberstruktur 210 auf. Das linke untere Teilbild präsentiert einen Schnitt 231 durch den Defekt 200 an der durch die gestichelte Linie 237 gekennzeichneten Position. In dem rechten oberen Teilbild ist die Fläche 300 eingezeichnet, die sowohl mit einem AFM als auch mit einem SEM gescannt werden, um eine dreidimensionale Kontur des Defekts 200 zu bestimmen. Die Spitze des AFMs bewegt sich bei dem Abtastvorgang entlang der strichlierten Linien über die Fläche 300. Die Höhe der Oberfläche der Absorberstruktur 210 wird wiederum mittels eines Schwellenwerts detektiert (linkes unteres Teilbild).

Wie bei dem Defekt 30 treten beim Bestimmen der dreidimensionalen Kontur des Defekts 200 entlang der Kanten 232 mit einem AFM wiederum prinzipielle messtechnischen Schwierigkeiten auf, die bereits im Rahmen der Diskussion der Fig. 2 ausführlich diskutiert wurden. In dem rechten unteren Teilbild ist nochmals zur Visualisierung der Probleme schematisch die Spitze 160 des AFMs dargestellt. Entlang der Kanten 232 wird das Aspektverhältnis wiederum zu groß, so dass das AFM in diesen Bereich die dreidimensionale Kontur des Defekts 200 nicht realitätsnah nachbilden kann.

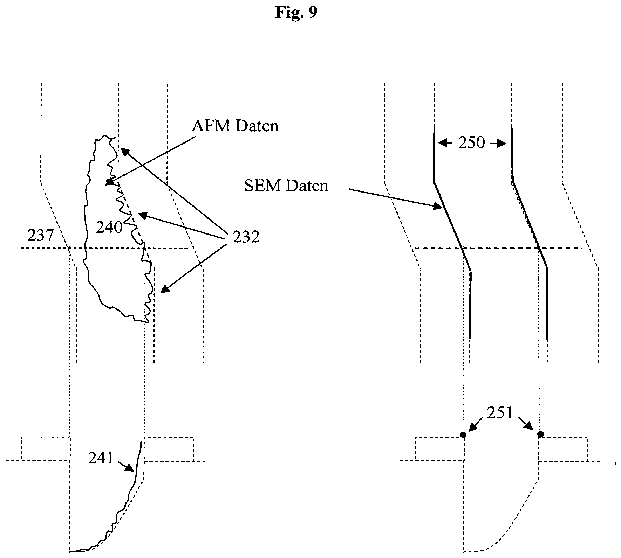

Die Figur 9 präsentiert in Aufsicht im linken oberen Teilbild schematisch die aus dem AFM-Scan bestimmte dreidimensionale Kontur 240 des Defekts 200 und im oberen rechten Teilbild den aus dem SEM-Scan bestimmten Verlauf 250 der Kanten 232. Zur Verdeutlichung der Lage des Defekts 200 und des Verlaufs 250 der Kanten 232 sind in der Fig. 9 zusätzlich gestrichelt die benachbarten Absorberstrukturen 210 sowie die Kanten 232 die Vertiefung 220 des Substrats 100 eingezeichnet. Die unteren Teilbilder der Fig. 9 veranschaulichen einen Schnitt 241 der dreidimensionalen Kontur 240 des Defekts 200 entlang der Linie 237 und einen Schnitt 251 des Verlaufs 250 der Kante 232 wiederum an der durch die gestrichelten Linie 237 angedeuteten Position. Die aus dem AFM-Scan bestimmte dreidimensionale Kontur 240 bildet die Grundfläche des Defekts 200 in dem zum Substrat 100 begrenzten Gebiet gut ab. Ohne die eingezeichneten Kanten 232 wäre es jedoch schwierig, allein aus der dreidimensionalen Kontur 240 des Defekts 200 seinen Verlauf entlang der Kante 232 zu bestimmen.

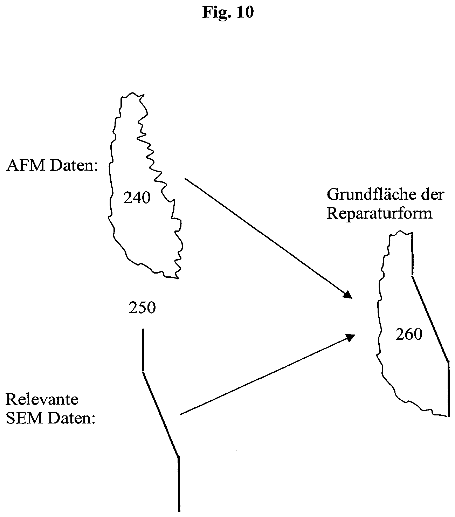

Die Fig. 10 veranschaulicht nochmals schematisch wie aus der dreidimensionalen Kontur 240 und aus dem Verlauf 250 der Kanten 232 die Reparaturform 260 des Defekts 200 ermittelt wird. Dazu wird - gegebenenfalls nach einer Größenanpassung - die Kontur 240 an dem Verlauf 250 der Kanten 232 ausgerichtet. Sodann erfolgt ein Schneiden der Kontur 240 an dem Verlauf 250 der Kanten 232. Der Verlauf 250 der Kanten 232 bildet wiederum die Begrenzung der Reparaturform 260 entlang der Kanten 232 der Vertiefung 220 des Substrats 100.

Wie bereits oben erläutert ist eine realitätsnahe Bestimmung der Höhe der Defekte 30, 200 in einem Bereich entlang der Kanten 32, 232 mit Hilfe eines AFM-Scans nicht möglich. Es ist deshalb in einer Abwandlung der oben beschriebenen Ausführungsbeispiele des erfindungsgemäßen Verfahrens möglich, diesen Bereich bei der Ermittlung der Teilchenstrahldosis der Reparaturformen 60, 260 außer Betracht zu lassen.

In einer weiteren Modifikation des erfindungsgemäßen Verfahrens können die Reparaturformen 60, 260 entlang den Kanten 32, 232 der Vertiefungen 120, 220 des Substrats 100 der Photomaske verkleinert werden, so dass sie zu jedem Punkt der Kanten 32, 232 einen Mindestabstand einhalten. Umgekehrt können die Reparaturformen 60, 260 so vergrößert werden, dass sie entlang der Kanten 32, 232 einen Mindestbereich in diese hineinragen.

Ferner ist es möglich, eine mathematische Optimierungsmethode, wie z.B. die oben erwähnte von J.S. Villarubia, zur Verbesserung der dreidimensionalen Konturen 40, 240 eines AFM-Scans mit dem in dieser Anmeldung beschriebenen Verfahren zu kombinieren (J.S. Villabubia, Algorithms for Scanned Proble Microscope Image Simulation, Surface and Reconstruction, J. Res. Natl. Inst. Stand. Technol. 102, 425, (1997)).

Das erläuterte erfindungsgemäße Verfahren umgeht die prinzipiellen messtechnischen Probleme von AFM-Scans in dem Bereich großer Aspektverhältnisse. Dadurch ermöglicht das offenbarte Verfahren das Ermitteln einer Reparaturform, die den ihr zugrunde liegenden Defekt realitätsnah abbildet. Die so bestimmten Reparaturformen erlauben eine weitgehende Reparatur von Defekten auf bzw. in Photomasken auch entlang steiler und hoher Kanten des Substrats der Photomaske.

Weitere Ausführungsformen der Erfindung sind im Folgenden zusammengefasst:
1. Verfahren zum Ermitteln einer Reparaturform (60, 260) eines Defekts (30, 200) an oder in der Nähe einer Kante (32, 232) eines Substrats (100) einer Photomaske, aufweisend:
   a. Scannen des Defekts (30, 200) mit einem Rastersondenmikroskop zum Bestimmen einer dreidimensionalen Kontur des Defekts (40, 240);
   b. Scannen des Defekts (30, 200) mit einen Rasterteilchenmikroskop zum Bestimmen eines Verlaufs (50, 250) der zumindest einen Kante (32, 232) des Substrats (100);
   c. Ermitteln der Reparaturform (60, 260) des Defekts (30, 200) aus einer Kombination der dreidimensionalen Kontur (40, 240) und dem Verlauf (50, 250) der zumindest einen Kante (32, 232).
2. Verfahren nach Ausführungsform 1, wobei die Kombination der dreidimensionalen Kontur (40, 240) und dem Verlauf (50, 250) der zumindest einen Kante (32, 232) das Bilden einer Schnittmenge aus der dreidimensionalen Kontur (40, 240) und dem Verlauf (50, 250) der Kante (32, 232) umfasst.
3. Verfahren nach Ausführungsform 1 oder 2, wobei das Rastersondenmikroskop ein Kraftmikroskop umfasst.
4. Verfahren nach einer der Ausführungsformen 1 - 3, wobei das Rasterteilchenmikroskop ein Rasterelektronenmikroskop umfasst.
5. Verfahren nach einer der Ausführungsformen 1 - 4, wobei der Verlauf (50, 250) der Kante (32, 232) aus Topologiekontrastdaten und/oder Materialkontrastdaten des Rasterteilchenmikroskop-Scans bestimmt wird.
6. Verfahren nach einer der Ausführungsformen 1 - 5, wobei die Schnittmenge bestimmt wird durch den Schritt des Ausrichtens des Rastersondenmikroskop-Scans an dem aus dem Rasterteilchen-Mikroskop bestimmten Verlauf (50, 250) der Kante (32, 232) und den Schritt des Schneidens des Rastersondernmikroskop-Scans mit dem Verlauf der Kante (32, 232).
7. Verfahren nach einer der Ausführungsformen 1 - 6, wobei die Reparaturform (60, 260) Koordinaten des Defekts in einer Ebene (190) seiner maximalen Ausdehnung senkrecht zu der Teilchenstrahlrichtung umfasst und eine Teilchenstrahldosis zum Reparieren des Defekts (30, 200).
8. Verfahren nach einer der Ausführungsformen 1 - 7, wobei die Reparaturform (60, 260) in eine Anzahl von diskreten Punkten eingeteilt ist und jeder Punkt eine Teilchenstrahldosis umfasst, die aus den Daten des Rastersondenmikroskop-Scans ermittelt wird.
9. Verfahren nach Ausführungsform 8, wobei die Teilchenstrahldosis der einzelnen Punkte der Reparaturform (60, 260) aus einer Interpolation mehrerer Punkte des Rastersondenmikroskop-Scans ermittelt wird.
10. Verfahren nach einer der Ausführungsformen 1 - 9, wobei die Reparaturform (60, 200) des Defekts (30, 200) entlang zumindest einer Kante (32, 232) der Photomaske zumindest einen Mindestabstand einhält.
11. Verfahren nach einer der Ausführungsformen 1 - 10, wobei die Reparaturform (60, 260) des Defekts (30, 200) entlang zumindest einer Kante (32, 232) der Photomaske zumindest einen Mindestbereich in diese hineinragt.
12. Verfahren zum Reparieren einer Photomaske, wobei eine Reparaturform (60, 260) nach einer der Ausführungsformen 1 - 11 verwendet wird.
13. Vorrichtung zum Ermitteln einer Reparaturform (60, 260) eines Defekts (30, 200) an oder in der Nähe einer Kante (32, 232) eines Substrats (100) einer Photomaske, aufweisend:
   a. zumindest ein Rastersondenmikroskop zum Scannen des Defekts und zum Übertragen der gescannten Daten;
   b. zumindest ein Rasterteilchenmikroskop zum Scannen des Defekts und Übertragen der gescannten Daten; und
   c. zumindest eine Datenverarbeitungseinheit, die aus den Daten des Rastersondenmikroskop-Scans eine dreidimensionale Kontur (40, 240) des Defekts (30, 200) bestimmt, aus dem Daten des Rasterteilchenmikroskop-Scans einen Verlauf (50, 250) zumindest einer Kante (32, 232) des Substrats (100) bestimmt und die Reparaturform (60, 260) des Defekts (30, 200) aus einer Kombination der dreidimensionalen Kontur (40, 240) und dem Verlauf (50, 250) der zumindest einen Kante (32, 232) ermittelt.
14. Vorrichtung nach Ausführungsform 13, wobei die Kombination der dreidimensionalen Kontur (40, 240) und dem Verlauf (50, 250) der zumindest einen Kante (32, 232) das Bilden einer Schnittmenge der dreidimensionalen Kontur (40, 240) und dem Verlauf (50, 250) der Kante (32, 232) umfasst.

## Patentansprüche

1. Verfahren zum Ermitteln einer Reparaturform (60, 260) eines Defekts (30, 200) an oder in der Nähe einer Kante (32, 232) eines Substrats (100) einer Photomaske, aufweisend:
a. Scannen des Defekts (30, 200) mit einem Rastersondenmikroskop zum Bestimmen einer dreidimensionalen Kontur (40, 240) des Defekts (30, 200);
b. Scannen des Defekts (30, 200) mit einem Rasterteilchenmikroskop zum Bestimmen eines Verlaufs (50, 250) der zumindest einen Kante (32, 232) des Substrats (100); und
c. Ermitteln der Reparaturform (60, 260) des Defekts (30, 200) aus einer Kombination der dreidimensionalen Kontur (40, 240) und dem Verlauf (50, 250) der zumindest einen Kante (32, 232), wobei die Kombination der dreidimensionalen Kontur (40, 240) und dem Verlauf (50, 250) der zumindest einen Kante (32, 232) das Bilden einer Schnittmenge aus der dreidimensionalen Kontur (40, 240), die mittels des Scannens des Defekts (30, 200) mit dem Rastersondenmikroskop bestimmt wurde, und dem Verlauf (50, 250) der Kante (32, 232), die mittels des Scannens des Defekts (30, 200) mit dem Rasterteilchenmikroskop bestimmt wurde, umfasst.

2. Verfahren nach Anspruch 1, wobei das Rastersondenmikroskop ein Kraftmikroskop umfasst.

3. Verfahren nach Anspruch 1 oder 2, wobei das Rasterteilchenmikroskop ein Rasterelektronenmikroskop umfasst.

4. Verfahren nach einem der Ansprüche 1 - 3, wobei der Verlauf (50, 250) der Kante (32, 232) aus Topologiekontrastdaten und/oder Materialkontrastdaten des Rasterteilchenmikroskop-Scans bestimmt wird.

5. Verfahren nach einem der Ansprüche 1 - 4, wobei die Schnittmenge bestimmt wird durch den Schritt des Ausrichtens des Rastersondenmikroskop-Scans an dem aus dem Rasterteilchen-Mikroskop bestimmten Verlauf (50, 250) der Kante (32, 232) und den Schritt des Schneidens des Rastersondenmikroskop-Scans mit dem Verlauf der Kante (32, 232).

6. Verfahren nach einem der Ansprüche 1 - 5, wobei die Reparaturform (60, 260) Koordinaten des Defekts in einer Ebene (190) seiner maximalen Ausdehnung senkrecht zu der Teilchenstrahlrichtung umfasst und eine Teilchenstrahldosis zum Reparieren des Defekts (30, 200).

7. Verfahren nach einem der Ansprüche 1- 6, wobei die Reparaturform (60, 260) in eine Anzahl von diskreten Punkten eingeteilt ist und jeder Punkt eine Teilchenstrahldosis umfasst, die aus den Daten des Rastersondenmikroskop-Scans ermittelt wird.

8. Verfahren nach Anspruch 7, wobei die Teilchenstrahldosis der einzelnen Punkte der Reparaturform (60, 260) aus einer Interpolation mehrerer Punkte des Rastersondenmikroskop-Scans ermittelt wird.

9. Verfahren nach einem der Ansprüche 1 - 8, wobei die Reparaturform (60, 260) des Defekts (30, 200) entlang zumindest einer Kante (32, 232) der Photomaske zumindest einen Mindestabstand einhält.

10. Verfahren nach einem der Ansprüche 1 - 9, wobei die Reparaturform (60, 260) des Defekts (30, 200) entlang zumindest einer Kante (32, 232) der Photomaske zumindest einen Mindestbereich in diese hineinragt.

11. Verfahren zum Reparieren einer Photomaske, wobei eine Reparaturform (60, 260) verwendet wird, die mit einem Verfahren nach einem der Ansprüche 1 - 10 ermittelt wird.

12. Vorrichtung zum Ermitteln einer Reparaturform (60, 260) eines Defekts (30, 200) an oder in der Nähe einer Kante (32, 232) eines Substrats (100) einer Photomaske, aufweisend:
a. zumindest ein Rastersondenmikroskop zum Scannen des Defekts und zum Übertragen der gescannten Daten;
b. zumindest ein Rasterteilchenmikroskop zum Scannen des Defekts und zum Übertragen der gescannten Daten; und
c. zumindest eine Datenverarbeitungseinheit, die ausgebildet ist, um aus den Daten des Rastersondenmikroskop-Scans eine dreidimensionale Kontur (40, 240) des Defekts (30, 200) zu bestimmen, um aus den Daten des Rasterteilchenmikroskop-Scans einen Verlauf (50, 250) zumindest einer Kante (32, 232) des Substrats (100) zu bestimmen und die ferner ausgebildet ist, um die Reparaturform (60, 260) des Defekts (30, 200) aus einer Kombination der dreidimensionalen Kontur (40, 240) und dem Verlauf (50, 250) der zumindest einen Kante (32, 232) zu ermitteln, wobei die Datenverarbeitungseinheit ferner ausgebildet ist zum Bilden einer Schnittmenge aus der dreidimensionalen Kontur (40, 240), die aus den Daten des Rastersondenmikroskop-Scans bestimmt wurde, und aus dem Verlauf (50, 250) der zumindest einen Kante (32, 232), die aus den Daten des Rasterteilchenmikroskop-Scans bestimmt wurde.

## Claims

1. Method for determining a repair shape (60, 260) of a defect (30, 200) on or in the vicinity of an edge (32, 232) of a substrate (100) of a photomask, comprising:
a. scanning the defect (30, 200) with a scanning probe microscope to determine a three-dimensional contour (40, 240) of the defect (30, 200);
b. scanning the defect (30, 200) with a scanning particle microscope to determine a course (50, 250) of the at least one edge (32, 232) of the substrate (100); and
c. determining the repair shape (60, 260) of the defect (30, 200) from a combination of the three-dimensional contour (40, 240) and the course (50, 250) of the at least one edge (32, 232), wherein the combination of the three-dimensional contour (40, 240) and the course (50, 250) of the at least one edge (32, 232) comprises forming an overlap from the three-dimensional contour (40, 240) which has been determined by means of scanning the defect (30, 200) with the scanning probe microscope and the course (50, 250) of the edge (32, 232) which has been determined by means of scanning the defect (30, 200) with the scanning particle microscope.

2. Method according to Claim 1, wherein the scanning probe microscope comprises a force microscope.

3. Method according to Claim 1 or 2, wherein the scanning particle microscope comprises a scanning electron microscope.

4. Method according to one of Claims 1 - 3, wherein the course (50, 250) of the edge (32, 232) is determined from topology contrast data and/or material contrast data from the scanning particle microscope scan.

5. Method according to one of Claims 1 - 4, wherein the overlap is determined by means of the step of aligning the scanning probe microscope scan on the course (50; 250) of the edge (32, 232) determined from the scanning particle microscope, and the step of forming an intersection of the scanning probe microscope scan with the course of the edge (32, 232).

6. Method according to one of Claims 1 - 5, wherein the repair shape (60, 260) comprises coordinates of the defect in a plane (190) of its maximum extent perpendicular to the particle beam direction and a particle beam dose for repairing the defect (30, 200).

7. Method according to one of Claims 1 - 6, wherein the repair shape (60, 260) is divided up into a number of discrete points and each point comprises a particle beam dose, which is determined from the data from the scanning probe microscope scan.

8. Method according to Claim 7, wherein the particle beam dose of the individual points of the repair shape (60, 260) is determined from an interpolation of multiple points from the scanning probe microscope scan.

9. Method according to one of Claims 1 - 8, wherein the repair shape (60, 260) of the defect (30, 200) maintains at least one minimum distance along at least one edge (32, 232) of the photomask.

10. Method according to one of Claims 1 - 9, wherein the repair shape (60, 260) of the defect (30, 200) projects into the photomask by at least a minimum extent along at least one edge (32, 232) of the latter.

11. Method for repairing a photomask, wherein use is made of a repair shape (60, 260) which is determined by using a method according to one of Claims 1 - 10.

12. Apparatus for determining a repair shape (60, 260) of a defect (30, 200) on or in the vicinity of an edge (32, 232) of a substrate (100) of a photomask, having:
a. at least one scanning probe microscope to scan the defect and to transmit the scanned data;
b. at least one scanning particle microscope to scan the defect and to transmit the scanned data; and
c. at least one data processing unit, which is designed to determine a three-dimensional contour (40, 240) of the defect (30, 200) from the data from the scanning probe microscope scan, in order to determine a course (50, 250) of at least one edge (32, 232) of the substrate (100) from the data from the scanning particle microscope scan, and which is also designed to determine the repair shape (60, 260) of the defect (30, 200) from a combination of the three-dimensional contour (40, 240) and the course (50, 250) of the at least one edge (32, 232), wherein the data processing unit is also designed to form an overlap from the three-dimensional contour (40, 240) which has been determined from the data from the scanning probe microscope scan and from the course (50, 250) of the at least one edge (32, 232) which has been determined from the data from the scanning particle microscope scan.

## Revendications

1. Procédé destiné à la détermination d'une forme de réparation (60, 260) d'un défaut (30, 200) sur ou à proximité d'une bordure (32, 232) d'un substrat (100) d'un masque photographique, présentant :
a. la numérisation du défaut (30, 200) au moyen d'un microscope à sonde de balayage en vue de la détermination d'un contour (40, 240) en trois dimensions du défaut (30, 200) ;
b. la numérisation du défaut (30, 200) au moyen d'un microscope à balayage et à faisceau de particules en vue de la détermination d'un tracé (50, 250) de la tout au moins une bordure (32, 232) du substrat (100) ; et
c. la détermination de la forme de réparation (60, 260) du défaut (30, 200) à partir d'une combinaison du contour (40, 240) en trois dimensions et du tracé (50, 250) de la tout au moins une bordure (32, 232),
selon lequel la combinaison du contour (40, 240) en trois dimensions et du tracé (50, 250) de la tout au moins une bordure (32, 232) comprend la formation d'une intersection à partir du contour (40, 240) en trois dimensions, laquelle a été déterminée par la numérisation du défaut (30, 200) au moyen du microscope à sonde de balayage, ainsi qu'à partir du tracé (50, 250) de la bordure (32, 232), laquelle a été déterminée par la numérisation du défaut (30, 200) au moyen du microscope à balayage et à faisceau de particules.

2. Procédé selon la revendication 1, selon lequel le microscope à sonde de balayage comprend un microscope à force atomique.

3. Procédé selon la revendication 1 ou 2, selon lequel le microscope à balayage et à faisceau de particules comprend un microscope électronique à balayage.

4. Procédé selon l'une des revendications 1 à 3, selon lequel le tracé (50, 250) de la bordure (32, 232) est déterminé à partir des données de contraste de topologie et/ou des données de contraste entre les matériaux de la numérisation du microscope à balayage et à faisceau de particules.

5. Procédé selon l'une des revendications 1 à 4, selon lequel l'intersection est déterminée par la phase d'alignement de la numérisation du microscope à sonde de balayage vis-à-vis du tracé (50, 250) de la bordure (32, 232), lequel a été déterminé à partir du microscope à balayage et à faisceau de particules, ainsi que par la phase du point d'intersection de la numérisation du microscope à sonde de balayage avec le tracé de la bordure (32, 232).

6. Procédé selon l'une des revendications 1 à 5, selon lequel la forme de réparation (60, 260) comprend, perpendiculairement à la direction du faisceau de particules, des coordonnées du défaut dans un plan (190) de son extension maximale, ainsi qu'une dose du faisceau de particules en vue de la réparation du défaut (30, 200).

7. Procédé selon l'une des revendications 1 à 6, selon lequel la forme de réparation (60, 260) est divisée en un certain nombre de points discrets et chaque point comprend une dose du faisceau de particules, laquelle est déterminée à partir des données de numérisation du microscope à sonde de balayage.

8. Procédé selon la revendication 7, selon lequel la dose du faisceau de particules des différents points de la forme de réparation (60, 260) est déterminée à partir d'une interpolation de plusieurs points de numérisation du microscope à sonde de balayage.

9. Procédé selon l'une des revendications 1 à 8, selon lequel la forme de réparation (60, 260) du défaut (30, 200) maintient tout au moins une distance minimale le long de la tout au moins une bordure (32, 232) du masque photographique.

10. Procédé selon l'une des revendications 1 à 9, selon lequel la forme de réparation (60, 260) du défaut (30, 200) pénètre, le long de la tout au moins une bordure (32, 232) du masque photographique, tout au moins sur une plage minimale, à l'intérieur de celui-ci.

11. Procédé destiné à la réparation d'un masque photographique, selon lequel une forme de réparation (60, 260) est employée, laquelle est déterminée au moyen d'un procédé selon l'une des revendications 1 à 10.

12. Dispositif destiné à la détermination d'une forme de réparation (60, 260) d'un défaut (30, 200) sur ou à proximité d'une bordure (32, 232) d'un substrat (100) d'un masque photographique, présentant :
a. tout au moins un microscope à sonde de balayage en vue de la numérisation du défaut et de la transmission des données numérisées ;
b. tout au moins un microscope à balayage et à faisceau de particules en vue de la numérisation du défaut et de la transmission des données numérisées ; et
c. tout au moins une unité de traitement des données, laquelle est conçue en vue de déterminer un contour (40, 240) en trois dimensions du défaut (30, 200) à partir des données de numérisation du microscope à sonde de balayage, en vue de déterminer un tracé (50, 250) de tout au moins une bordure (32, 232) du substrat (100) à partir des données de numérisation du microscope à balayage et à faisceau de particules et laquelle unité de traitement des données est en outre conçue en vue de déterminer la forme de réparation (60, 260) du défaut (30, 200) à partir d'une combinaison du contour (40, 240) en trois dimensions et du tracé (50, 250) de la tout au moins une bordure (32, 232) ;
selon lequel l'unité de traitement des données est en outre conçue en vue de la formation d'une intersection à partir du contour (40, 240) en trois dimensions, lequel a été déterminé à partir des données de numérisation du microscope à sonde de balayage, ainsi qu'à partir du tracé (50, 250) de la tout au moins une bordure (32, 232), laquelle a été déterminée à partir des données de numérisation du microscope à balayage et à faisceau de particules.
